# EUROPÄISCHE PATENTANMELDUNG

(11) **EP 3 144 579 A1**
(43) Veröffentlichungstag der Anmeldung: **22.03.2017**
(21) Anmeldenummer: 16181287.0
(22) Anmeldetag: 19.02.2015
(51) Int. Cl.: F21K 99/00, F21V 29/00

(54) **LED-STREIFEN, LAMPE**

(30) Priorität: 28.02.2014 DE 202014001943 U
(62) Teilanmeldung aus: 15155710.5
(71) Anmelder: vosla GmbH, 08523 Plauen (DE)
(72) Erfinder: PETER, Alexander, 08538 Weischlitz (DE); WINKLER, Markus, 97941 Tauberbischofsheim (DE); SACHS, Peter, 08539 Rosenbach/Vogtl. OT Rodau (DE); BÖTTCHER, Matthias, 08258 Wohlhausen (DE)
(74) Vertreter: Isarpatent

(57) **Zusammenfassung**

Die vorliegende Erfindung betrifft ein LED-Streifen für eine oder in einer Retrofit-Lampe, mit zumindest zwei Kontakten (2, 2') zum leitenden Kontaktieren des LED-Streifens (1; 1'), mit einer Vielzahl von entlang dem LED-Streifen angeordneten LED-Chips, wobei die Kontakte und/oder die LED-Chips derart an dem LED Streifen angeordnet sind, dass ihre Verteilung an das Temperaturprofil im Betrieb des LED-Streifens angepasst ist und/oder dass das Temperaturprofil im Betrieb des LED-Streifens geglättet ist. Die Erfindung betrifft ferner eine Lampe mit einem solchen LED-Streifen.

## Beschreibung

### GEBIET DER ERFINDUNG

Die vorliegende Erfindung betrifft einen LED-Streifen sowie eine Lampe, insbesondere Retrofit-Lampe, mit einer Leuchtmittelanordnung die einen solchen LED-Streifen enthält.

### TECHNISCHER HINTERGRUND

Lampen existieren in den verschiedensten Ausführungsformen. Eine in der Vergangenheit äußerst verbreitete Lampenart stellen Glühlampen in Form der sogenannte "Glühbirne" dar. Derartige Glühlampen setzen jedoch einen hohen Anteil der durch Sie verbrauchten Energie in Wärme um, weshalb sie relativ ineffizient sind. Des Weiteren werden für Glühlampen in der EU im Zuge der Umsetzung der Ökodesign-Richtlinie 2005/32/EG stufenweise Herstellungs- und Vertriebsverbote in den Mitgliedsländern umgesetzt.

Für den Ersatz von Glühlampen werden zunehmend auf Leuchtdioden (LED) basierende Lampen eingesetzt. Im Gegensatz zu der herkömmlichen Glühlampe mit Glaskolben, Glühdraht und Sockel sind LEDs keine Temperaturstrahler, sodass deren Lichtausbeute sehr hoch ist. Inzwischen stehen auch LEDs mit ausreichend hoher Lichtausbeute zur Verfügung, so dass sie auch für Anwendungen mit hoher Lichtstrahlung verwendet werden können. Zum Anmeldezeitpunkt ist der verfügbare Lichtstrom von LEDS so hoch, dass diese bei vergleichbarer Baugröße und vergleichbaren Herstellkosten auch bei einer elektrischen Vergleichsbetrachtung zunehmend in Konkurrenz zu Glühlampen treten können.

Im Zuge der Umsetzung der Ökodesign-Richtlinie 2005/32/EG werden zunehmend so genannte Retrofit-Lampen angeboten, bei denen es sich um LED-Leuchtquellen handelt, die im Design einer bekannten Glühlampe bzw. Glühbirne gleichen und die somit einen Lampensockel aufweisen, der in eine herkömmliche Leuchtenfassung eingesetzt werden kann.

Solche Retrofit-Lampen sind in der Literatur vielfach erwähnt, beispielsweise in der DE 20 2013 000 980 U1 und der DE 10 2009 035 515 A1. Bei auf LED basierenden Retrofit-Lampen sind die entsprechenden LEDs im Inneren des Glaskolbens angeordnet, wie beispielsweise in der DE 20 2011 000 010 U1, der DE 20 2013 000 980 U1 und der DE 10 2007 038 216 A1 beschrieben.

Die vorliegende Erfindung sowie die ihr zugrunde liegende Idee wird nachfolgend anhand einer solchen LED basierten Retrofit-Lampe erläutert, jedoch ohne die Erfindung, darauf zu beschränken.

Eine Problemstellung bei LED-Lampen stellt die Wärmeabfuhr dar. LEDs erzeugen trotz ihrer hohen Lichtausbeute durch ihren elektrischen Widerstand Wärme, welche die LED-Chips (auch "LED-Dies" genannt) schädigen und/oder ihre Leuchtkraft verringern kann, falls die Wärme nicht in ausreichendem Maße abgeführt wird. Ferner besteht bei Retrofit-Lampen auch die Anforderung einer ansprechenden Optik und einer hohen Lichtausbeute, das heißt einer möglichst geringen Verschattung durch interne Bauteile der Lampe.

Eine Retrofit-Lampe, welche sich diesen Anforderungen annimmt, ist in dem deutschen Gebrauchsmuster DE 20 2013 009 434.6 U1 der Anmelderin beschrieben. Diese Retrofit-Lampe weist sogenannte LED-Streifen, auch LED-Strings genannt, auf. Dabei handelt es sich um eine Vielzahl von LED-Chips, die auf einem Substrat aufgereiht angeordnet sind. Die durch die LEDs erzeugte Wärme wird mittels eines gasförmigen Wärmeübertragungsmediums, welches im Inneren der Hülle der Retrofit-Lampe eingebracht ist, zu der als Kühlkörper fungierenden Hülle transportiert

### ZUSAMMENFASSUNG DER ERFINDUNG

Vor diesem Hintergrund liegt der vorliegenden Erfindung die Aufgabe zugrunde, eine verbesserte Lampe anzugeben.

Erfindungsgemäß wird diese Aufgabe durch einen LED-Streifen mit den Merkmalen des Anspruchs 1 und/oder durch eine Lampe mit den Merkmalen des Anspruches 10 gelöst.

Demgemäß ist vorgesehen:
- Ein LED-Streifen, insbesondere für eine oder in einer Retrofit-Lampe, mit zumindest zwei Kontakten zum leitenden Kontaktieren des LED-Streifens, mit einer Vielzahl von entlang dem LED-Streifen angeordneten LED-Chips, wobei die Kontakte und/oder die LED-Chips derart an dem LED Streifen angeordnet sind, dass ihre Verteilung an das Temperaturprofil im Betrieb des LED-Streifens angepasst ist und/oder dass das Temperaturprofil im Betrieb des LED-Streifens geglättet ist.
- Eine Lampe, insbesondere Retrofit-Lampe, mit einem Lampensockel, mit einer mit dem Lampensockel verbundenen, zumindest teiltransparenten geschlossenen Hülle, welche derart ausgebildet ist, als Kühlkörper für die Lampe zu fungieren, mit einer Leuchtmittelanordnung, welche innerhalb der Hülle angeordnet ist und zumindest einen LED-Streifen gemäß einem der vorstehenden Ansprüche aufweist, mit einem gasförmigen Wärmeübertragungsmedium, welches im Inneren der Hülle eingebracht ist und welches dazu ausgebildet ist, von der Leuchtmittelanordnung erzeugte thermische Energie zu der als Kühlkörper fungierenden Hülle zu transportieren.

Die der vorliegenden Erfindung zugrunde liegende Erkenntnis besteht darin, dass der Temperaturverlauf innerhalb eines herkömmlichen LED-Streifens, insbesondere einer herkömmlichen Retrofit-Lampe, ungleichmäßig ist. Die Kontakte, welche die Wärme, insbesondere zusätzlich zum Wärmeübertragungsmedium, ableiten, befinden sich an den Enden des LED-Streifens. In der Mitte des LED-Streifens wird somit weniger Wärme abgeleitet als an den Enden, wodurch sich ein gewisser Wärmestau bildet. Daher herrschen in der Mitte des LED-Streifens, welche einen von den Kontakten beabstandeten Fernbereich der Kontakte darstellt, im Betrieb höhere Temperaturen als an den einen Nahbereich der Kontakte darstellenden Enden des LED-Streifens. Somit werden die in der Mitte des LED-Streifens angeordneten LED-Chips des LED-Streifens thermisch stärker belastet, als die an den Enden angeordneten LED-Chips.

Die der vorliegenden Erfindung zugrunde liegende Idee besteht nun darin, die Verteilung bzw. Anordnung der LED-Chips zu variieren. Alternativ oder zusätzlich wird erfindungsgemäß die Verteilung bzw. Anordnung der Kontakte entlang des LED-Streifens variiert.

Auf diese Weise kann zum einen das Temperaturprofil des LED-Streifens im Betrieb geglättet werden. Die Glättung ist als eine Reduzierung der Temperaturunterschiede zu verstehen. Insbesondere ist darunter die Reduzierung des Wärmestaus in der Mitte des LED-Streifens zu verstehen. Dabei kann das Temperaturniveau in der Mitte gesenkt und an den Enden angehoben werden, sodass das Temperaturprofil insgesamt gleichmäßiger verläuft. Bevorzugt verläuft das Temperaturprofil entlang des gesamten LED-Streifens auf einem mittleren Niveau. Besonders Bevorzugt werden die LED-Chips und/oder die Kontakte dabei derart angeordnet, dass im Fernbereich der Kontakte im Betrieb ein annähernd gleiches Temperaturniveau vorliegt, wie im Nahbereich.

Alternativ oder zusätzlich kann die Anordnung bzw. Verteilung erfindungsgemäß auch variiert werden, um sie an das Temperaturprofil im Betrieb des LED-Streifens anzupassen. Dabei werden temperaturempfindlichere Elemente, insbesondere Wärmeempfindlichere Typen von LED-Chips, an im Betrieb tendenziell kälteren und weniger temperaturempfindliche Elemente, z. B. weniger wärmeempfindliche Typen von LED-Chips oder Kontakte, an im Betrieb tendenziell wärmeren Stellen des LED-Streifens angeordnet.

Unter einer Vielzahl von LED-Chips im Sinne der vorliegenden Erfindung ist eine unbeschränkte Anzahl von LED-Chips größer als zwei zu verstehen. Dies ist dadurch bedingt, dass minimal drei LED-Chips notwendig sind, damit unterschiedliche Abstände zwischen benachbarten LED-Chips zustande kommen können und/oder unterschiedliche Abstände zwischen LED-Chips und Kontakten unter Erzielung eines geglätteten Temperaturprofils möglich sind und/oder unterschiedliche Anordnungen verschiedener Elemente in wärmeren und kälteren Bereichen möglich sind.

Vorteilhafte Ausgestaltungen und Weiterbildungen ergeben sich aus den weiteren Unteransprüchen sowie aus der Beschreibung unter Bezugnahme auf die Figuren der Zeichnung.

Bei einer Ausführungsform sind die entlang dem LED-String angeordneten LED-Chips unterschiedlich weit voneinander beabstandet. Somit kann vorteilhaft das Wärmeaufkommen durch Variation der Abstände der LED-Chips eingestellt werden. Beispielsweise kann zur Glättung des Temperaturprofils an einer thermisch weniger belasteten Stelle der Abstand zwischen zwei LED-Chips verringert werden und an einer thermisch höher belasteten Stelle der Abstand zwischen zwei LED-Chips vergrößert werden. Somit wird das Temperaturniveau an der vormals thermisch weniger belasteten Stelle angehoben und das der vormals einer thermisch höher belasteten Stelle gesenkt.

Bei einer bevorzugten Ausführungsform sind die LED-Chips im Nahbereich der Kontakte geringer voneinander beabstandet als in einem Fernbereich der Kontakte. Die Kontakte sind aufgrund ihrer leitenden Eigenschaften imstande, Wärme abzuleiten. Insofern stellen die Nahbereiche der Kontakte im Allgemeinen thermisch weniger belastete Bereiche dar, da in diesen Nahbereichen über die Kontakte eine zusätzliche Wärmeabfuhr erfolgt. Im Fernbereich der Kontakte liegt eine solche zusätzliche Wärmeabfuhr nicht vor, weshalb die Fernbereiche der Kontakte thermisch tendenziell höher belastet sind. Durch die unterschiedliche Beabstandung der LED-Chips kann diesem Effekt entgegengewirkt werden. Dadurch, dass die LED-Chips im Fernbereich weiter voneinander beabstandet als im Nahbereich, wird im Fernbereich, in welchem die Wärmeabfuhr schwieriger ist, die Wärme auf eine größer Fläche verteilt und somit ein Wärmestau vermieden oder reduziert. Im Nahbereich der Kontakte wird durch die geringeren Abstände zwar nun mehr Wärme pro Fläche erzeugt, was das Temperaturniveau erhöht, jedoch kann diese Wärme auch über die Kontakte gut abgeleitet werden. Insgesamt wird somit im Fernbereich der Kontakte ein geringeres Temperaturniveau und im Nahbereich der Kontakte ein etwas höheres Temperaturniveau erzeugt, wodurch der Temperaturverlauf insgesamt geglättet wird.

Gemäß einer weiteren Ausführungsform ist der LED-Streifen mit unterschiedlichen Typen von LED-Chips besetzt. Die unterschiedlichen Typen von LED-Chips weisen unterschiedliche Wärmeempfindlichkeiten auf. Wärmeempfindlichere Typen von LED-Chips sind zumindest vorwiegend, d.h. vorwiegend oder vollständig, im Nahbereich der Kontakte angeordnet. Mit im Nahbereich der Kontakte ist sowohl der Nahbereich jedes einzelnen Kontakts als auch die Gesamtheit aller Nahbereiche aller Kontakte bezeichnet. D. h. es wäre auch denkbar, dass sich alle LED-Chips eines wärmeempfindlicheren Typs im Nahbereich nur eines der Kontakte befinden. Ferner können die LED-Chips eines wärmeempfindlicheren Typs auch auf die Nahbereiche eines Teils der Kontakte oder aller Kontakte verteilt sein. Vorteilhaft können diese wärmeempfindlicheren Typen von LED-Chips somit keinem Wärmestau ausgesetzt werden, da die Kontakte eine zusätzliche Wärmeableitung bereitstellen. Die weniger wärmeempfindlichen Typen von LED-Chips sind demnach eher im Fernbereich der Kontakte angeordnet. Falls in einem LED-Streifen ein Temperaturstau entsteht, geschieht dies eher im Fernbereich der Kontakte. Im Nahbereich der Kontakte wird hingegen trotzdem eine gute oder zumindest eine bessere Wärmeableitung vorliegen. Insofern schützt diese Anordnung die wärmeempfindlicheren Typen von LED-Chips auch im Falle eines Wärmestaus.

Bei einer vorteilhaften Ausführungsform enthält der LED-Streifen zumindest ein teiltransparentes Substrat. Das teiltransparente Substrat weist im Vergleich zu Glas eine hohe Wärmeleitfähigkeit auf. Bevorzugt ist die Wärmeleitfähigkeit zumindest zehnmal höher als von Glas.

Bei einer Ausführungsform enthält das Substrat ein Material, welches eine Kristallstruktur aufweist. Besonders bevorzugt enthält das Substrat Saphir. Bei 25°C beträgt die Wärmeleitfähigkeit von Saphir etwa 41,9 W/(m·K), während die Wärmeleitfähigkeit von handelsüblichem Silikatglas zwischen 0,8 und 1 W/(m·K) beträgt. Insofern wird durch die Verwendung von Saphir anstatt von Glas eine sehr viel höhere Wärmeleitfähigkeit des Substrats bereitgestellt, was vorteilhaft die Ableitung der durch die LEDs emittierten Wärme begünstigt, so dass insgesamt das Temperaturprofil des LED-Streifens leichter geglättet werden kann. Des Weiteren ist Saphir ein transparentes und elektrisch isolierendes Material, womit es gut für ein Substrat geeignet ist.

Bei einer alternativen Ausführungsform enthält das Substrat ein Metall. Bevorzugt handelt es sich bei dieser Ausführungsform bei dem Substrat um ein Verbundmaterial aus Metall und einer transparenten Matrix, wie transparenten Kunststoffen (Thermoplast, Duroplast, oder Elastomer) oder Glas (Hartglas, Weichglas, Quarzglas). Denkbar wäre auch, dass das Substrat, zumindest anteilig, aus Metall besteht.

Bei einer Ausführungsform weist das Metall eine gitterartige Ausbildung mit durchgehenden Ausnehmungen auf. Durch die durchgehenden Ausnehmungen entsteht eine Teiltransparenz des Metalls. Das Metall ist aufgrund seiner hohen Wärmeleitfähigkeit vorteilhaft zur Glättung des Temperaturprofils einsetzbar. Beispielsweise kann das gitterartig ausgebildete Metall als eine Schicht im Substrat vorgesehen sein. Die gitterartige Ausbildung kann in den verschiedensten Ausführungsformen vorliegen. Entscheidend ist dabei, dass ein LED-Chip vom Material des Gitters nicht vollständig verdeckt sein kann, so dass von dem LED-Chip emittiertes Licht durch eine Ausnehmung durch das Substrat hindurch dringen kann. Andererseits sollte genügend Material vorhanden sein, damit der LED-Chip, vorzugsweise elektrisch isoliert, daran befestigt werden kann und/oder nicht durch das Gitter hindurch fallen kann. Vorzugsweise ist die Größe der Ausnehmungen daher auf die Größe der LED-Chips abgestimmt. Falls konstruktionsbedingt eine Isolation der LED-Chips gegen das Substrat erforderlich ist wird dies beispielsweise durch die Verwendung eines elektrisch isolierenden transparenten Klebstoffes gewährleistest.

Bei einer Ausführungsform ist die gitterartige Ausbildung als Drahtgewebe realisiert. Es handelt sich dabei um metallische Drähte, welche voneinander beabstandet miteinander verwebt sind. Die Ausnehmungen liegen jeweils zwischen den einzelnen Drähten vor. Alternativ kann die gitterartige Ausbildung auch in Form eines Metallschwammes realisiert sein. Dieser ist als ein poröses Metall mit durchgehenden Poren als Ausnehmungen ausgebildet. Die Ausnehmungen können gleichmäßig oder ungleichmäßig groß sein. Des Weiteren können die Ausnehmungen gleichmäßig oder ungleichmäßig verteilt angeordnet sein. Auch hier ist wiederum entscheidend, dass ein Chip nicht von dem Material des Metallschwamms vollständig verdeckt wird.

Bei einer Ausführungsform bildet das Metall zwei voneinander elektrisch isolierte Bereiche aus, welche sich zumindest abschnittsweise entlang der Längsausbildung des Substrats erstrecken. Bei einer bevorzugten Variante dieser Ausführungsform erstrecken sich die elektrisch isolierten Bereiche kontinuierlich entlang der Längsausbildung des Substrats. Somit ist eine gute Wärmeleitung des Substrats in Längsrichtung gewährleistet.

Bei einer Ausführungsform sind die voneinander elektrisch isolierten Bereiche mit je einem der Kontakte kontaktiert. Insbesondere können sie auch einteilig mit den Kontakten ausgebildet sein. Alternativ oder bevorzugt zusätzlich sind die voneinander elektrisch isolierten Bereiche zur elektrischen Kontaktierung der LED-Chips ausgebildet und angeordnet. Somit können die voneinander elektrisch isolierten Bereiche als längs verlaufende elektrische Zuleitung von den Kontakten zu den LED-Chips genutzt werden. Gleichzeitig ist es dadurch auch ermöglicht eine Rückseite des LED-Streifens mit LED-Chips oder anderen Halbleiterelementen oder optoelektronischen Elementen zu besetzen und diese ebenfalls über die voneinander elektrisch isolierten Bereiche des Metalls zu kontaktieren. Dabei kann es sich beispielsweise um so genannte Suppressordioden, auch Transient Absorption Zener Diode (TAZ-Diode) oder Transient Voltage Suppressor Diode (TVS-Diode) genannt, handeln, welche zum Schutz elektronischer Schaltungen vor Spannungsimpulsen dienen. Insbesondere sind die voneinander elektrisch isolierten Bereiche des Metalls dazu zur Kontaktierung auf beiden Seiten des LED-Streifens ausgebildet und angeordnet.

Bei einer Ausführungsform sind zumindest zwei LED-Chips zwischen den voneinander elektrisch isolierten Bereichen in Reihe geschaltet. Bevorzugt sind mehrere Reihenschaltungen von zumindest zwei LED-Chips zwischen den voneinander elektrisch isolierten Bereichen parallel geschaltet. Somit kann die Gesamtspannung des LED-Streifens unabhängig von der Gesamtlänge angepasst werden, indem jeweils Gruppen von gleich vielen Chips parallel geschaltet werden. Durch die Parallelschaltung erhöht sich auch die Anzahl der im Substrat verbauten Verbindungsleitungen, insbesondere in Form von so genannten Bond Drähten, die mit den Bereichen des Metalls direkt verbunden sind. Dies führt aufgrund der Wärmeleitungseigenschaften der Verbindungsleitungen zu einer gleichmäßigeren Wärmeverteilung im Substrat. Ein weiterer Vorteil der Parallelschaltung von Gruppen von LED-Chips ist, dass bei der Verarbeitung der LED-Streifen ein "Auf-Länge-Schneiden" der LED-Streifen, das heiß ein Abschneiden oder Kappen der LED-Streifen auf eine gewünschte Länge angepasst an die jeweilige Anwendung möglich ist. Insbesondere ist dies auch unabhängig von der Kontaktierung möglich. Dazu können die Kontakte beispielsweise seitlich vom Substrat weggeführt werden bzw. ausgebildet sein.

Bei einer Ausführungsform sind die zueinander parallel geschalteten Reihenschaltungen in Längsrichtung des Substrats voneinander beabstandet angeordnet. Somit wird das "Auf-Länge-Schneiden" noch erleichtert, weil dieses dann in einem Zwischenraum zwischen voneinander beabstandet angeordneten Reihenschaltungen erleichtert vorgenommen werden kann, ohne diese zu beschädigen.

Bei einer anderen Ausführungsform bildet das Metall zumindest zwei elektrisch isolierte Bereiche aus, welche jeweils in Längsrichtung des Substrats voneinander beabstandet angeordnet sind. Somit wird die Wärmeleitung im Substrat unterstützt. Bevorzugt sind die jeweils an einem längsseitigen Ende des Substrats angeordneten voneinander elektrisch isolierten Bereiche mit je einem der Kontakte kontaktiert. Alternativ oder bevorzugt zusätzlich sind die voneinander elektrisch isolierten Bereiche ferner zur elektrischen Kontaktierung der LED-Chips ausgebildet und angeordnet. Somit können die elektrisch isolierten Bereiche als elektrische Zuleitung von den Kontakten zu den randseitigen LED-Chips des LED-Streifens genutzt werden. Des Weiteren können zwischen den einzelnen LED-Chips ebenfalls voneinander elektrisch isolierte Bereiche des Metalls vorgesehen sein, welche eine Zwischenkontaktierung bereitstellen können. Gleichzeitig ist durch die voneinander elektrisch isolierten Bereiche des Metalls auch ein Besetzen einer Rückseite des LED-Streifens mit LED-Chips ermöglicht, falls die Kontaktierung auf beiden Seiten des LED-Streifens zur Verfügung steht. Insbesondere sind die voneinander elektrisch isolierten Bereiche des Metalls dazu zur Kontaktierung auf beiden Seiten des LED-Streifens ausgebildet und angeordnet. Bei einer Ausführungsform sind zwischen zwei voneinander elektrisch isolierten Bereichen je zumindest ein LED-Chip und ein anderes Halbleiterelement oder optoelektronisches Element parallel geschaltet. Somit können andere Halbleiterelemente, z. B. TVS-Dioden, oder optoelektronische Elemente mit sehr geringem Aufwand in den LED-Streifen eingefügt werden, ohne dessen Länge zu ändern. Alternativ können zwischen zwei voneinander elektrisch isolierten Bereichen auch je zumindest zwei LED-Chips parallel geschaltet sein. Beide Ausführungen haben den Vorteil, dass durch die Parallelschaltung mehrerer Elemente die Länge des LED-Streifens auch verkürzt werden kann. Gleichzeitig dienen die voneinander elektrisch isolierten Bereiche des Metalls jeweils als Zwischenkontakte bzw. Bondkontakte, was wiederum die nachgelagerte Parallelschaltung weiterer Elemente bzw. LED-Chips zum jeweils nächsten elektrisch isolierten Bereich ermöglicht.

Bei einer Ausführungsform weist das Substrat eine transparente Matrix auf, die zumindest im Bereich der Ausnehmungen der gitterartigen Ausbildung vorgesehen ist. Bevorzugt wird eine transparente Kunststoffmatrix verwendet. Auf diese Weise kann beispielsweise dem Drahtgewebe eine mechanische Steifigkeit verliehen werden, wodurch das Substrat mechanisch stabiler ist. Selbiges trifft für den Metallschwamm zu. Die Matrix kann das Substrat auch zumindest teilweise einbetten. Ferner ist es auch denkbar, unter der gitterartigen Ausbildung und/oder im Kern des Substrats eine durchgehende Schicht der transparenten Matrix vorzusehen. Bei Ausführungsformen mit voneinander elektrisch isolierten Bereichen weist das Substrat eine transparente Matrix auf, die zumindest im Bereich zwischen zwei voneinander elektrisch isolierten Bereichen vorgesehen ist. Somit wirkt die Matrix als Isolator zwischen den Bereichen und bewirkt gleichzeitig eine mechanische stabile Struktur des Substrats.

Gemäß einer bevorzugten Ausführungsform ist das Substrat an mehreren Seiten mit LED-Chips besetzt. Somit ist eine direkte Abstrahlung in mehrere Raumrichtungen möglich. Weiterhin kann die Leistungsdichte des LED Streifens erhöht werden, da mehr LED-Chips pro Fläche angeordnet werden können.

Bei einer bevorzugten Ausführungsform ist an zumindest einem Endbereich des LED-Streifens eine Durchkontaktierung von einer ersten zu einer zweiten mit LED-Chips besetzten Seite des Substrats vorgesehen. Dies ist besonders vorteilhaft, weil dadurch die Kontakte des LED-Strings frei anordenbar sind. Mittels der Durchkontaktierung wird der Kontakt an der zweiten Seite zurückgeführt. Daher brauchen die Kontakte nicht in gegenüberliegenden Endbereichen vorgesehen sein, sondern können an einem beliebigen Ort angeordnet werden. So ist es beispielsweise möglich, beide Kontakte an demselben Endbereich vorzusehen. Ferner ist auch eine mittige Anordnung der Kontakte an dem LED-Streifen möglich.

Bei einer Ausführungsform sind die Kontakte längs des LED-Streifen voneinander beabstandet angeordnet. Das heißt, dass in Längsrichtung des LED-Strings ein Abstand zwischen den Kontakten vorliegt. Benachbarte LED-Chips im Bereich der Mitte zwischen zwei Kontakten sind dabei im Vergleich zu anderen benachbarten LED-Chips auf dem LED-String am Weitesten voneinander beabstandet angeordnet. Die Mitte zwischen den zwei Kontakten stellt dabei gleichzeitig den Fernbereich beider Kontakte dar. Dieser Bereich wäre bei gleichmäßiger Anordnung der LED-Chips daher am stärksten thermisch belastet, was durch die weite Beabstandung der LED-Chips in diesem Bereich vermieden wird.

Bei einer weiteren Ausführungsform sind die Kontakte im Bereich der Mitte des LED-Strings angeordnet. Somit wird die Kontaktierung des LED-Strings im Herstellungsprozess stark vereinfacht, da beide Kontakte nahezu an der gleichen Stelle des LED-Strings vorliegen. Bevorzugt sind an unterschiedlichen Seiten des Substrats jeweils in der Mitte ein Kontakt vorgesehen und an beiden Enden eine Durchkontaktierung vorgesehen. Dabei kann es sich um zwei gegenüberliegende oder um zwei angrenzende Seite des Substrats handeln. Dieses Prinzip kann bei einem quaderförmigen Substrat auch doppelt angewendet werden. D.h., dass alle vier Seiten des Substrats mit LED-Chips besetzt sind, wobei in einem Endbereich jeweils zwei angrenzende Seiten fortschreitend miteinander durchkontaktiert sind. Die Kontakte sind dabei beispielsweise an zwei gegenüberliegenden Seiten angeordnet. Somit sind einerseits lediglich zwei Kontakte notwendig, um die LED-Chips auf allen vier Seiten zu versorgen, was den Kontaktierungsaufwand bei der Montage stark verringert. Ferner bringt diese Anordnung auch mechanische Vorteile mit sich, da der LED-String durch die Kontakte in der Mitte gehaltert werden kann. Alternativ zur Mittigen Anordnung könnten auch beide Kontakte im gleichen Endbereich vorgesehen sein, wodurch ebenfalls eine vereinfachte Kontaktierung ermöglicht wäre. Bei mittiger Anordnung liegen im Vergleich zu einer endseitigen Anordnung beider Kontakte an einem gleichen Ende geringere Abstände zu den nicht gestützten Endseiten vor, was den Vorteil einer höheren Stabilität der Anordnung hat.

Bei einer weiteren Ausführungsform, bei welcher die Kontakte im Bereich der Mitte des LED-Strings angeordnet sind, sind benachbarte LED-Chips in zumindest einem Endbereich des LED-Strings im Vergleich zu anderen benachbarten LED-Chips auf dem LED-String am Weitesten voneinander beabstandet angeordnet. Da bei Anordnung der Kontakte im Bereich der Mitte auch die größte Wärmeabfuhr in der Mitte möglich ist, würde sich bei einer gleichmäßigen Anordnung der LED-Chips ein Wärmestau eher an den Endbereichen bilden. Insofern wird hier durch die weite Beabstandung der LED-Chips an den Endbereichen eine Glättung des Temperaturprofils erreicht.

Bei einer bevorzugten Ausführungsform sind die LED-Chips des zumindest einen LED-Streifens in einer 4π-Anordnung derart angeordnet, dass sie in alle Raumrichtungen wirken. Eine 4π-Anordnung bezeichnet dabei den Raumwinkel einer Kugel, was bedeutet, dass in alle Raumrichtungen Licht abgestrahlt wird.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: eine Draufsicht eines der Anmelderin bekannten LED-Streifens;
- Fig. 2: eine Draufsicht eines erfindungsgemäßen LED-Streifen;
- Fig. 3A: eine Seitenansicht eines der Anmelderin bekannten LED-Streifens;
- Fig. 3B: eine Seitenansicht eines erfindungsgemäßen LED-Streifens;
- Fig. 3C: ein Vergleichsdiagramm der Temperaturverläufe der LED-Streifen gemäß Figur 3A und 3B;
- Fig. 4: eine perspektivische Darstellung eines LED-Streifens;
- Fig. 5: eine Draufsicht eines erfindungsgemäßen LED-Streifen gemäß einer weiteren Ausführungsform;
- Fig. 6: eine perspektivische Darstellung eines LED-Streifens;
- Fig. 7: eine schematische Darstellung einer Anordnung von LED-Chips auf verschiedenen Seiten eines Substrats;
- Fig. 8A: eine schematische Detaildarstellung des Aufbaus eines Substrats gemäß einer alternativen Ausführungsform;
- Fig. 8B: eine weitere alternative Ausführungsform eines Substrats;
- Fig. 9: eine perspektivische Darstellung eines LED-Streifens;
- Fig. 10: einen LED-Streifen gemäß einer weiteren Ausführungsform;
- Fig. 11: eine perspektivische Darstellung eines LED-Streifens;
- Fig. 12: eine perspektivische Darstellung eines weiteren LED-Streifens;
- Fig. 13: eine perspektivische Darstellung eines noch weiteren LED-Streifens;
- Fig. 14: eine perspektivische Darstellung eines LED-Streifens;
- Fig. 15: eine Retrofit-Lampe.

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG VON AUSFÜHRUNGSBEISPIELEN

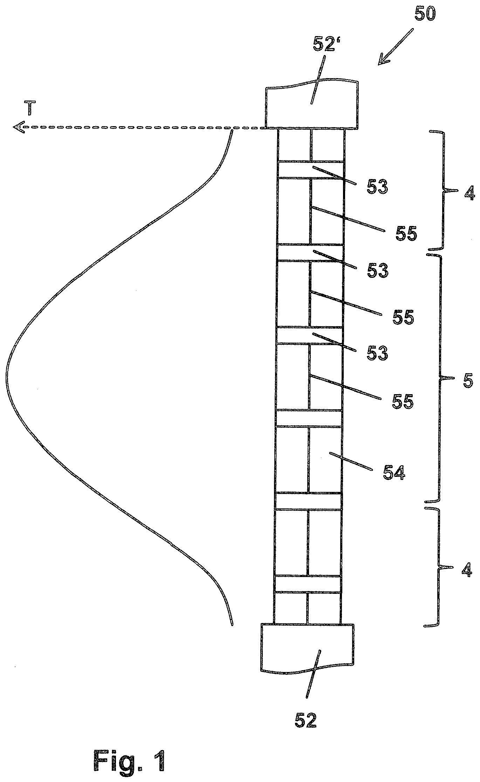

Figur 1 zeigt einen der Anmelderin bekannten LED-Streifen. Dieser weist zwei endseitige Kontakte 52, 52' sowie ein Substrat 54 auf. Das Substrat 54 verbindet die Kontakte 52, 52' mechanisch miteinander. Auf dem Substrat 54 sind LED-Chips 53 in Reihe zueinander, das heißt nacheinander angeordnet.

Jeweils benachbarte LED-Chips 53 sind über Verbindungsleitungen 55 elektrisch miteinander verbunden. Die LED-Chips 53 sind in Reihe miteinander verschaltet. Die randseitigen LED-Chips 53 sind jeweils elektrisch mit einem der Kontakte 52, 52' verbunden.

Zur Fixierung der Kontakte 52, 52' an dem Substrat kann eine Fixiervorrichtung vorgesehen sein, welche zur besseren Übersichtlichkeit nicht dargestellt ist. Einer erster Kontakt 52 bildet einen Anodenanschluss, während der zweite Kontakt 52' einen Kathodenanschluss bildet. Die LED-Chips 53 sind entsprechend verschaltet, so dass Strom in Durchflussrichtung der LED-Chips 53 entlang dem LED-Streifen fließen kann.

Ein derartiger LED-Streifen 50 weist im Betrieb ein Temperaturprofil T auf, wie es qualitativ in dem in Figur 1 mit T bezeichneten Diagramm dargestellt ist. Demnach liegt in einem Nahbereich 4 der Kontakte 52, 52' jeweils ein relativ niedriges Temperaturniveau vor, da die Kontakte 52, 52' die im Nahbereich 4 vorliegende Wärme ableiten können. In der Mitte des LED-Streifens 1, das heißt in einem Fernbereich 5 der Kontakte 52, 52', liegt hingegen ein relativ hohes Temperaturniveau vor. Der Grund dafür liegt darin, dass der Transportweg bis zu den Kontakten 52, 52' deutlich aus dem Fernbereich 5 deutlich länger ist als aus dem Nahbereich 4. Dies führt dazu, dass sich im Fernbereich 5 die Wärme, insbesondere von den in der Mitte des LED-Streifens angeordneten LED-Chips abgegebene Wärme, staut. Im Betrieb werden daher die im Fernbereich 5 angeordneten LED-Chips 53 thermisch stärker belastet, als die im Nahbereich 4 der Kontakte 52, 52' angeordneten LED-Chips 53.

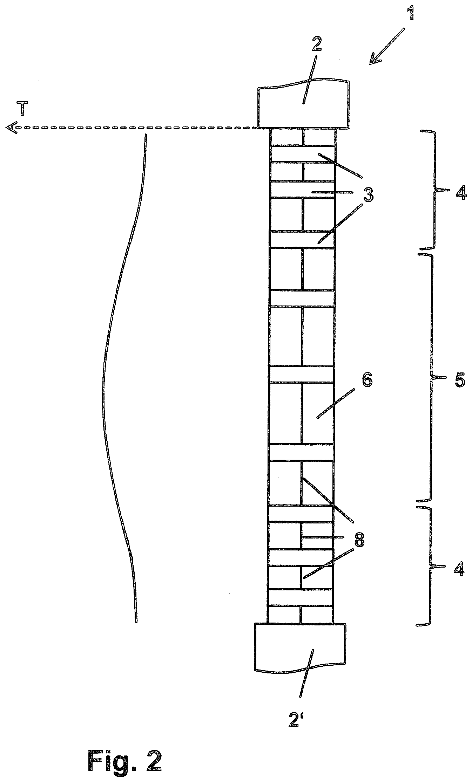

Figur 2 zeigt einen erfindungsgemäßen LED-Streifen 1. Dieser weist zwei endseitige Kontakte 2, 2' auf, welche über ein Substrat 6 mechanisch miteinander verbunden sind. Auf dem Substrat 6 sind LED-Chips 3 aufgebracht, welche über Verbindungsleitungen 8 elektrisch miteinander verbunden sind.

Im Unterschied zu dem in Figur 1 dargestellten LED-Streifen 50 weist der LED-Streifen 1 eine andere Verteilung bzw. Anordnung der LED-Chips 3 auf. Benachbarte LED-Chips 3 sind entlang dem LED-Streifen 1 unterschiedlich weit voneinander beabstandet. Im Nahbereich 4 der Kontakte 2, 2' sind die LED-Chips 3 geringer voneinander beabstandet als in dem Fernbereich 5 der Kontakte 2, 2'. Im Bereich der Mitte des LED-Streifens 1, welche auch die Mitte zwischen den zwei Kontakten 2, 2' darstellt, liegt im Vergleich zu den anderen benachbarten LED-Chips 3 auf dem LED-Streifen der weiteste Abstand vor. Somit wird im Fernbereich 5 weniger Wärme pro Oberfläche in den LED-Streifen 1 eingebracht als im Nahbereich 4. Dadurch wird erreicht, dass im Betrieb ein deutlich geringerer Wärmestau im Fernbereich 5 des LED-Streifens entsteht. Dies wird auch dadurch unterstützt, dass durch die vergrößerte Oberfläche im Fernbereich mehr wäre an das umgebendes Medium abgegeben werden kann. Diese Effekte sind anhand des Temperaturprofils T dargestellt, welches den Temperaturverlauf entlang des LED-Streifens 1 qualitativ illustriert.

In den Nahbereichen 4 sind die LED-Chips wesentlich enger nebeneinander angeordnet, als im Fernbereich 5. Somit wird hier deutlich mehr Wärme pro Oberfläche in dem LED-Streifen eingebracht, weshalb das Temperaturniveau in den Nahbereichen 4 höher ist als bei dem in Figur 1 gezeigten LED-Streifen 50.

Im Fernbereich 5 liegt das Temperaturniveau hingegen deutlich unter dem des Fernbereichs des LED-Streifens 50 in Figur 1. Aufgrund dessen, dass die LED-Chips 3 im Fernbereich 5 weiter voneinander beabstandet angeordnet sind, wird hier weniger Wärme pro Fläche produziert. Der Wärmetransport über die Umgebung des LED-Streifens, insbesondere über ein Wärmeübertragungsmedium innerhalb einer Lampe wird durch die größere Oberfläche begünstigt. Das Wärmeübertragungsmedium kann beispielsweise als Gasfüllung der Lampe realisiert sein. Somit muss auch weniger Wärme über den langen Weg bis zu den Kontakten 2, 2' abtransportiert werden.

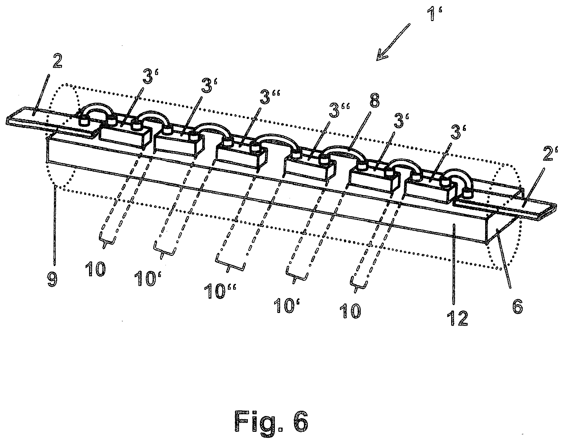

Innerhalb einer Retrofit-Lampe, wie sie in Bezug auf Figur 6 noch näher erläutert wird, steht für die Wärmeabfuhr über ein Wärmeübertragungsmedium im Bereich der Mitte des LED-Streifens durch die größeren Abstände so eine vergleichsweise große Oberfläche zur Verfügung, über welche Wärmeenergie an die Umgebung bzw. das den LED-Streifen umgebende Wärmeübertragungsmedium abgegeben werden kann. Somit trägt auch dieser Effekt zu einem deutlich geglätteten Temperaturprofil bei.

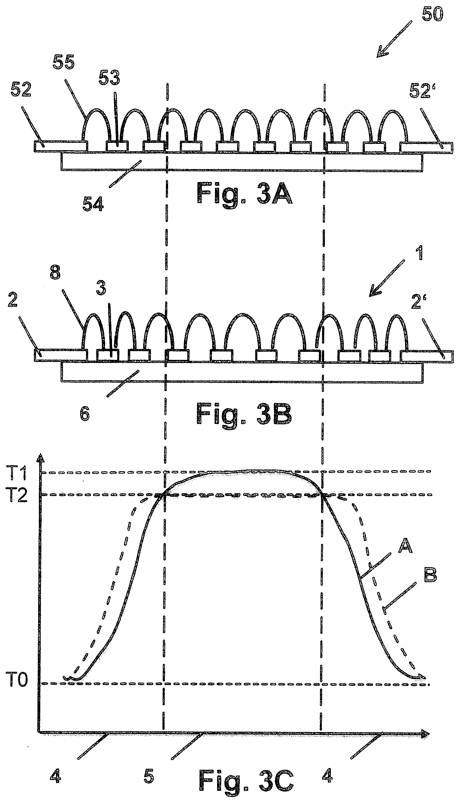

Fig. 3A zeigt eine Seitenansicht eines der Anmelderin bekannten LED-Streifens 50. Die Basis des LED-Streifens 50 bildet ein Substrat 54, auf welches Kontakte 52, 52' und in regelmäßigen Abständen LED-Chips 53 aufgesetzt sind. Dazwischen sind Verbindungsleitungen 55 vorgesehen.

Fig. 3B zeigt eine Seitenansicht eines erfindungsgemäßen LED-Streifens. Die Basis des LED-Streifens 1 bildet ein Substrat 4, auf welches Kontakte 2, 2' und unterschiedlich weit voneinander beabstandete LED-Chips 3 aufgesetzt sind.

Die Verteilung der LED-Chips 3 ist nach dem gleichen Prinzip wie bei dem LED-Streifen 1 gemäß Figur 2 vorgesehen. Dazwischen sind Verbindungsleitungen 8 vorgesehen.

Fig. 3C zeigt ein Vergleichsdiagramm der Temperaturverläufe A, B der LED-Streifen 50 und 1 gemäß Figur 3A und 3B. Der Temperaturverlauf A bezieht sich auf einen LED-Streifen 50 gemäß Figur 3A und der Temperaturverlauf B auf einen LED-Streifen 1 gemäß Figur 3B.

Das Vergleichsdiagramm zeigt einen deutlich homogeneren Temperaturverlauf B des LED-Streifens 1 im Vergleich zu einem heterogeneren Temperaturverlauf A des LED-Streifens 50. In der Mitte des LED-Streifens 50, welche einen Fernbereich 5 darstellt, schwellt die Temperatur an und liegt in der Spitze mit der Temperatur T1 deutlich höher als beim Temperaturverlauf B des LED-Streifens 1. Bei diesem liegt eine niedrigere Temperatur T2 gleichmäßig über den gesamten Fernbereich 5 an.

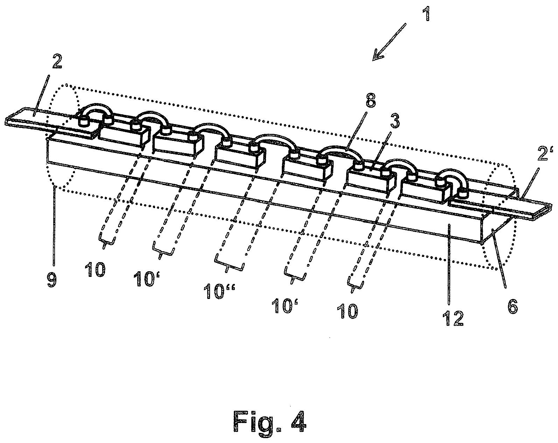

Figur 4 zeigt eine perspektivische Darstellung eines LED-Streifens 1. Dieser weist prinzipiell einen ähnlichen Aufbau wie der LED-Streifen 1 gemäß Figur 3B auf. Die einzelnen LED-Chips 3 sind in unterschiedlichen Abständen 10, 10', 10" zueinander angeordnet, wobei in den Nahbereichen 4 jeweils die kleinsten Abstände 10 vorgesehen sind und in der Mitte des LED-Streifens der größte Abstand 10" vorgesehen ist. Die LED-Chips 3 sind mittels als Bond Drähte ausgebildeten Verbindungsleitungen 3 verbunden.

Das Substrat 6 weist eine transparente Matrix 12 auf. Ferner ist der gesamte LED-Streifen 1 in eine schalenartige Umhüllung 9 eingelassen, welche eine Phosphor-Schicht enthält. Alternativ zu einer schalenartigen Umhüllung könnte die Phosphor-Schicht auch auf die Flächen des LED-Streifens 1 aufgebracht sein.

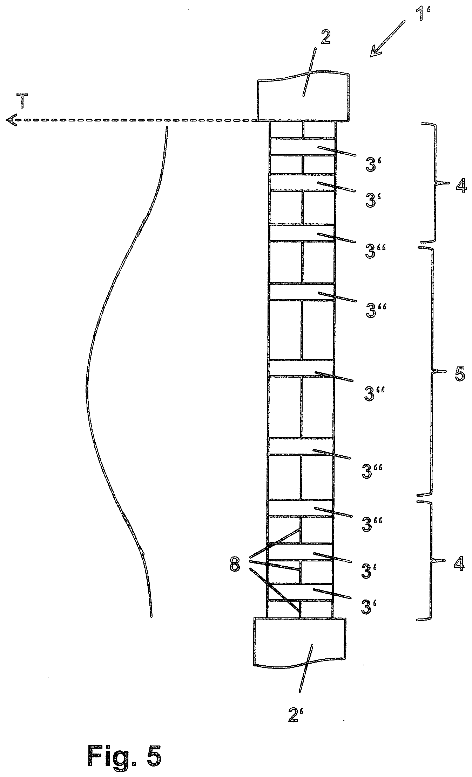

Figur 5 zeigt einen LED-Streifen 1' gemäß einer weiteren Ausführungsform. Im Unterschied zu dem in Figur 2 gezeigten LED-Streifen 1 weist der hier dargestellte LED-Streifen 1' unterschiedliche Typen von LED-Chips 3', 3" auf.

Bei der Anmelderin bekannten LED-Streifen mit unterschiedlichen Typen von LED-Chips wird eine gleichmäßige Verteilung der unterschiedlichen Typen über die Länge des LED-Chips, beispielsweise in abwechselnder Reihenfolge, vorgesehen. Bei dem hier dargestellten LED-Streifen 1' liegt jedoch eine andere Verteilung der unterschiedlichen Typen von LED-Chips 3', 3" vor.

Bei den LED-Chips 3' handelt es sich um einen Typus von LED-Chips, welcher relativ wärmeempfindlich ist. Bei den LED-Chips 3'' handelt es sich um weniger gegen Wärme empfindlichen Typus von LED-Chips. Beispielsweise kann es sich bei einem wärmeempfindlicheren Typus von LED-Chips 3' um "rote" LED-Chips handeln. D.h. sie senden im Betrieb Licht im roten Spektralbereich aus. Bei einem weniger wärmeempfindlichen Typus von LED-Chips 3'' handelt es sich beispielsweise um "blaue" LED-Chips, welche im Betrieb Licht im blauen Spektralbereich aussenden und gemeinhin weniger wärmeempfindlich sind als rote LED-Chips.

Gemäß dem vorliegenden Ausführungsbeispiel sind die wärmeempfindlicheren Typen von LED-Chips 3' im Nahbereich der Kontakte 2, 2' angeordnet. Die weniger wärmeempfindlichen Typen von LED-Chips 3'' sind im Fernbereich 5 angeordnet. Denkbar wäre auch, in den Nahbereich lediglich einen gegenüber dem Fernbereich erhöhten Anteil von wärmeempfindlicheren LED-Chips 3' vorzusehen und im Fernbereich lediglich einen niedrigeren Anteil vorzusehen, welcher dann aber bevorzugt am Rand des Fernbereichs vorgesehen ist. In der Mitte des LED-Streifens sind vorzugsweise ausschließlich weniger temperaturempfindliche LED-Chips 3" vorgesehen.

Durch diese Anordnung wird erreicht, dass die wärmeempfindlicheren LED-Chips 3' in tendenziell kälteren Bereichen des LED-Streifens angeordnet sind und somit weniger thermisch belastet werden, als die weniger wärmeempfindlichen LED-Chips 3". Des Weiteren ist in diesen Bereichen, in welchen die wärmeempfindlicheren LED-Chips 3' angeordnet sind, auch die Gefahr eines Wärmestaus geringer. Insgesamt werden die wärmeempfindlicheren LED-Chips 3' daher allein durch ihre Anordnung auf den LED-Streifen vor einer Schädigung durch zu hohe Temperatur geschützt. Die weniger wärmeempfindlicheren LED-Chips 3'' sind vorwiegend in den tendenziell wärmeren Abschnitten des LED-Streifens angeordnet, was für sie jedoch aufgrund der geringeren Wärmeempfindlichkeit nicht oder weniger schädlich ist. Insgesamt ist somit die Anordnung der unterschiedlichen Typen von LED-Chips 3', 3" an den Verlauf des Temperaturprofils bzw. an die Gefahr eines potentiellen Wärmestaus innerhalb des LED-Streifens 1' angepasst.

Zusätzlich zu der beschriebenen Verteilung der unterschiedlichen Typen von LED-Chips 3', 3" kann auch noch eine unterschiedliche Beabstandung der LED-Chips 3', 3" vorgesehen werden, um so das Temperaturprofil T auch etwas zu glätten. Somit ist zum einen der Verlauf des Temperaturprofils T einstellbar und zum anderen die Anordnung der unterschiedlichen Typen von LED-Chips 3', 3" an das Temperaturprofil T anpassbar.

Bei dem in Figur 3 gezeigten LED-Streifen 1' sind zwar im Bereich der Mitte bzw. im Fernbereich 5 etwas größere Abstände als im Nahbereich 4 der Kontakte 2, 2' vorgesehen, jedoch sind die Abstände hier weniger eng, als bei dem Ausführungsbeispiel gemäß Figur 2. Insofern ergibt sich hier ein eher moderat geglättetes Temperaturprofil, welches sozusagen einen Mittelweg zwischen den unterschiedlichen Temperaturprofilen T der Figuren 1 und 2 darstellt. Es liegt daher im Vergleich zu Figur 1 ein leicht erhöhtes Temperaturniveau in den Nahbereichen 4 vor, wobei das Temperaturniveau im Fernbereich 5 leicht gesenkt ist.

Figur 6 zeigt eine perspektivische Darstellung eines LED-Streifens 1'. Dieser weist prinzipiell einen ähnlichen Aufbau wie der LED-Streifen 1' gemäß Figur 5 auf. Unterschiedliche Typen von LED-Chips 3', 3" sind mit unterschiedlichen Abständen 10, 10', 10" zueinander auf dem Substrat 6 angeordnet. Im Nahbereich sind die kleinsten Abstände 10 vorgesehen und in der Mitte des LED-Streifens ist der größte Abstand 10" vorgesehen. Die wärmeempfindlicheren Typen von LED-Chips 3' sind im Nahbereich 4 der Kontakte 2, 2' angeordnet. Die weniger wärmeempfindlichen Typen von LED-Chips 3" sind im Fernbereich 5 angeordnet. Die LED-Chips sind mittels als Bond Drähte ausgebildeten Verbindungsleitungen 3 verbunden.

Das Substrat 6 weist eine transparente Matrix 12 auf. Ferner ist der gesamte LED-Streifen 1' in eine schalenartige Umhüllung 9 eingelassen, welche eine Phosphor-Schicht enthält. Alternativ zu einer schalenartigen Umhüllung könnte die Phosphor-Schicht auch auf die Flächen des LED-Streifens 1 aufgebracht sein.

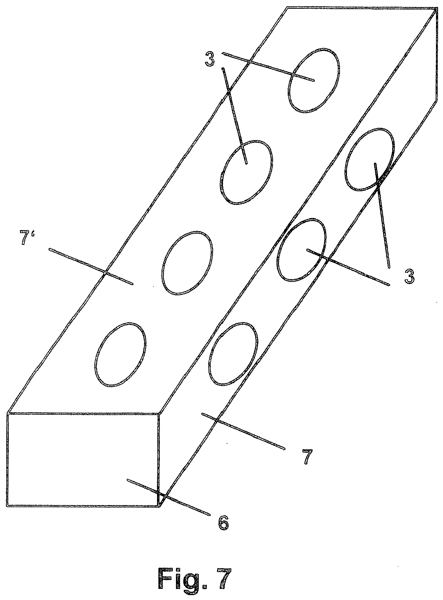

Figur 7 zeigt schematisch eine Anordnung von LED-Chips 3 an mehreren Seiten 7, 7' eines Substrats 6. Das Substrat 6 ist quaderförmig ausgebildet und weist eine längliche Form auf. An den sichtbaren Seiten 7, 7' des Substrats sind jeweils LED-Chips 3 angeordnet. An den in dieser Darstellung nicht sichtbaren Seiten des quaderförmigen Substrats können ebenfalls LED-Chips angeordnet sein. Eine derartige mehrseitige Anordnung von LED-Chips auf einem Substrat hat die Anmelderin bereits in der DE 20 2013 009 434.6 U1 beschrieben, worauf Bezug genommen wird. Das Substrat muss dabei keine gerade quaderförmige Ausbildung haben, sondern kann gegebenenfalls auch geschwungen ausgebildet sein.

Im Unterschied zu den in der DE 20 2013 009 434.6 U1 beschriebenen LED-Streifen weist der in dieser Ausführungsform dargestellte LED-Streifen ein Substrat 6 auf, ein kristallines Material enthält, das elektrisch nicht leitend ist. Des Weiteren ist das Material transparent und weist im Vergleich zu Glas eine hohe Wärmeleitfähigkeit auf. Bevorzugt ist die Wärmeleitfähigkeit zumindest zehnfach höher als die Wärmeleitfähigkeit für Glas.

Besonders bevorzugt enthält das Substrat dazu Saphir. Insbesondere besteht das Substrat zu einem überwiegenden Anteil oder vollständig aus Saphir. Saphir hat bei 25°C eine Wärmeleitfähigkeit von 41,9 W/(m·K). Dies stellt für Isolierstoffe eine vergleichsweise hohe Wärmeleitfähigkeit dar. Bei Glas liegt die Wärmeleitfähigkeit bei 25° im Bereich von 0,8 bis 1 W/(m·K). Somit liegt die Wärmeleitfähigkeit von Saphir etwa 40 Mal höher, obwohl es sich dennoch um ein elektrisch isolierendes Material handelt. Die erhöhten Wärmeleitfähigkeit des Substrats erleichtert das in Bezug auf die Figuren 2 und 3 beschriebene Glätten des Temperaturprofils T des LED-Streifens, weil die Ableitung von Wärme aus dem Fernbereich 5 der Kontakte 2, 2' dadurch einfacher möglich ist als bei einer niedrigen Wärmeleitfähigkeit.

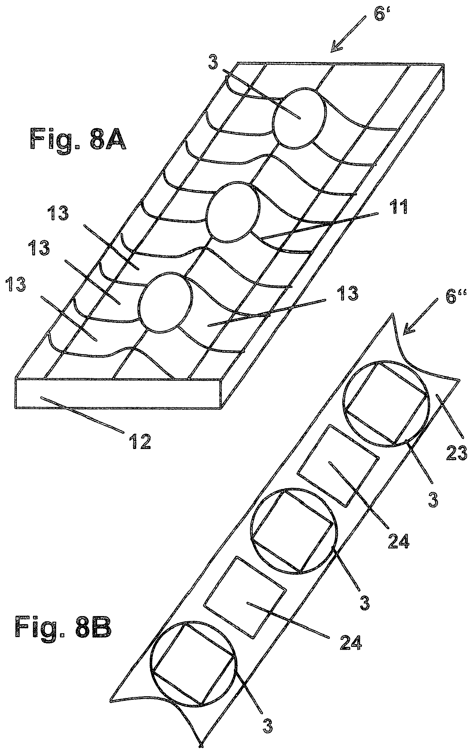

Figur 8A zeigt eine alternative Ausführungsform der Ausbildung eines Substrats 6'. Das Substrat 6' weist ein Drahtgewebe 11 auf, welches eine gitterartige Ausbildung mit durchgehenden Ausnehmungen 13 aufweist. Das Drahtgewebe 11 ist in das Substrat 6' integriert vorgesehen. Es kontaktiert die LED-Chips 3 aber nicht elektrisch, sondern dient lediglich der verbesserten Wärmeleitung.

Die elektrische Verbindung der LED-Chips 3 ist analog zu Figur 2 mit Verbindungsleitungen 8 realisiert, welche zur besseren Übersichtlichkeit nicht dargestellt sind. Alternativwäre es denkbar, dass einer der Drähte des Drahtgewebes gegenüber den restlichen Drähten des Drahtgewebes elektrisch isoliert ist und als elektrische Verbindungsleitungen der LED-Chips 3 ausgebildet ist.

Das Drahtgewebe 11 ist in eine transparente Matrix12 eingebettet, welche bei dieser Ausführungsform als eine Kunststoffmatrix realisiert ist und dem Substrat 6' eine erhöhte Steifigkeit verleiht.

Die Ausnehmungen 13 sind groß genug, dass von den LED-Chips 3 ausgestrahltes Licht durch das Substrat 6' hindurch strahlen kann. Somit weist das Substrat 6' eine Teiltransparenz auf.

Figur 8B zeigt eine weitere Ausführungsform eines alternativen Substrats 6". Dieses weist ein Blech 23 auf, in welches ausgestanzte oder ausgeschnittene Ausnehmungen 24 eingebracht sind, welche derart angeordnet sind, dass eine gitterartige Ausbildung des Blechs 23 vorliegt. Auf dem Substrat 6" sind jeweils zumindest teilweise im Bereich einer Ausnehmung 24 LED-Chips 3 angeordnet. Die elektrische Kontaktierung der einzelnen LED-Chips ist hier zur besseren Übersichtlichkeit nicht dargestellt. Analog zu dem Drahtgewebe 11 dient auch das Blech 23 nicht der elektrischen, sondern lediglich der Wärmeleitung innerhalb des Substrats.

Die Ausnehmungen 24 weisen eine Größe auf, welche derart ausgelegt ist, dass ein auf dem Substrat 6" angeordneter LED-Chip 3 nicht ganz durch das Material des Blechs verdeckt sein kann, sondern dass stets ein von dem LED-Chip 3 ausgesendetes Licht zumindest anteilig durch eine der Ausnehmungen 24 hindurch strahlen kann. Somit wird eine Teiltransparenz des Substrats 6" realisiert. Ferner sind die Ausnehmungen 24 etwas kleiner als die LED-Chips ausgebildet, so dass ein LED-Chip nicht durch eine Ausnehmung 24 hindurch fallen kann.

Denkbar wäre, dass die Ausnehmungen 24 mit einer transparenten Kunststoffmatrix ausgefüllt sind oder das gesamte Blech 23 in eine transparente Kunststoffmatrix eingebettet ist. In diesem Fall könnten die Ausnehmungen 24 auch größer als die LED-Chips 3 ausgebildet und/oder in die transparente Kunststoffmatrix zumindest teilweise eingebettet sein.

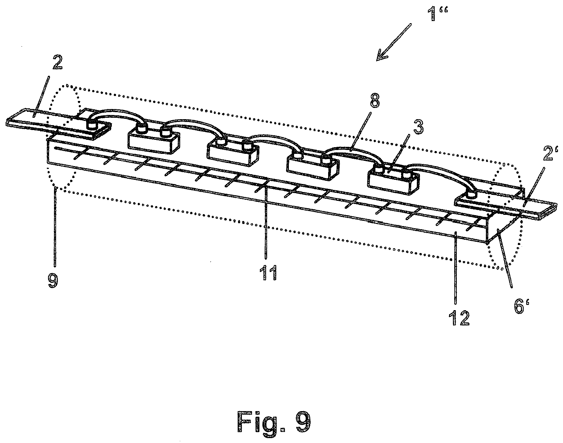

Figur 9 zeigt eine perspektivische Darstellung eines LED-Streifens 1". Dieser weist ein Substrat 6'auf, welches hinsichtlich seines Aufbaues dem Substrat 6' gemäß Figur 8A gleicht. Die einzelnen LED-Chips 3 sind in regelmäßigen Abständen zueinander angeordnet Die LED-Chips sind mittels Bond Drähten als Verbindungsleitungen 3 verbunden.

Das Substrat 6' weist eine transparente Matrix 12 und ein Drahtgewebe 11 auf. Das Drahtgewebe 11 ist in eine transparente Kunststoffmatrix 12 eingelassen. Es kontaktiert die LED-Chips 3 nicht elektrisch, sondern dient der verbesserten Wärmeleitung zur Glättung des Temperaturprofils T im Betrieb des LED-Streifens 1".

Alternativ zu dem Substrat 6' mit Drahtgewebe 11 könnte auch ein Substrat 6" gemäß Figur 8B in dem LED-Streifen 1" vorgesehen sein. In diesem Fall wäre ein Blech 23 in die transparente Matrix eingelassen, in welches ausgestanzte oder ausgeschnittene Ausnehmungen 24 eingebracht sind. Alternativ können auch nur die Ausnehmungen 24 mit einer transparenten Matrix ausgefüllt sein.

Bei der transparenten Matrix 12 handelt es sich bevorzugt um eine Kunststoffmatrix.

Ferner ist der gesamte LED-Streifen in eine schalenartige Umhüllung 9 eingelassen, welche eine Phosphor-Schicht enthält. Alternativ zu einer schalenartigen Umhüllung könnte die Phosphor-Schicht auch auf die Flächen des LED-Streifens 1 aufgebracht sein.

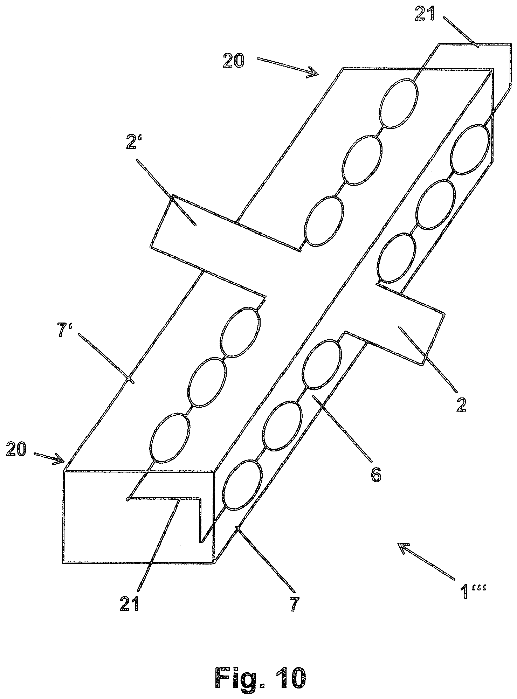

Figur 10 zeigt eine weitere Ausführungsform eines erfindungsgemäßen LED-Streifens 1"'. Dieser weist ein in länglicher Quaderform ausgebildetes Substrat 6 auf. Im Unterscheid zu den vorangehend beschriebenen Ausführungsbeispielen weist der LED-Streifen 1"' mittig angeordnete Kontakte 2, 2' auf. Des Weiteren ist der LED-Streifen 1''' an beiden dargestellten Seiten 7, 7' mit LED-Chips 3 besetzt.

An beiden Endbereichen 20 des LED-Streifen 1"' sind Durchkontaktierungen 21 vorgesehen, welche die außenseitigen LED-Chips 3 der ersten Seite 7 mit den außenseitigen LED-Chips 3 der zweiten Seite 7' elektrisch leitend verbinden. Somit sind die LED-Chips von dem ersten Kontakt 2 jeweils nach außen, über die Durchkontaktierung zur anderen Seite des Substrats 6 und auf der anderen wieder zurück in die Mitte zum zweiten Kontakt 2' kontaktiert.

Bei einer alternativen Ausführungsform könnten auch beide Kontakte 2, 2' am gleichen Endbereich 20 des LED-Streifens 1"' vorgesehen sein und an dem gegenüberliegenden Endbereich 20 des LED-Streifens lediglich eine Durchkontaktierung 21 vorgesehen sein.

In beiden Fällen ist die Kontaktierung im Herstellungsprozess einer Lampe 30 deutlich erleichtert, da die Kontaktierung lediglich an einem gemeinsamen Ort stattfinden muss und nicht, wie bei den in Bezug auf die Figuren 1 bis 9 beschriebenen LED-Streifen, an zwei unterschiedlichen gegenüberliegenden Endbereichen des LED-Streifens.

Die Anordnung der Kontakte in der Mitte des LED-Streifens weist gegenüber der Anordnung der Kontakte im gleichen Endbereich den Vorteil auf, dass geringere freie Hebelarme vorhanden sind, weshalb die Halterung bzw. Lagerung an den Kontakten mechanisch stabiler bzw. weniger empfindlich gegen mechanische Einwirkungen ist.

Beide beschriebene Varianten stellen lediglich Beispiele für die Anordnung der Kontakte, welche durch eine Durchkontaktierung 21 ermöglicht wird, dar. Tatsächlich können die Kontakte mittels der Durchkontaktierung frei an einer frei bestimmbaren Position des LED-Streifens angeordnet sein.

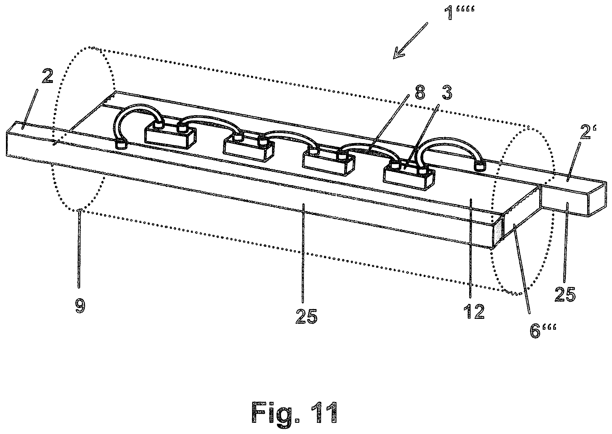

Fig. 11 zeigt eine perspektivische Darstellung eines weiteren LED-Streifens 1"". Dieser weist ein Substrat 6"' auf, welches zwei metallische, voneinander elektrisch isolierte Bereiche 25 und eine diese Bereiche 25 trennende transparente Matrix 12 aufweist. Die elektrisch voneinander isolierten Bereiche 25 erstrecken sich kontinuierlich entlang der Längsausbildung des Substrats 6"'. In der dargestellten Ausführungsform und begrenzen die Bereiche 25 das Substrat 6"' seitlich.

Die elektrisch voneinander isolierten Bereiche 25 sind einteilig mit je einem der Kontakte 2, 2' des LED-Streifens ausgebildet und elektrisch mit den LED-Chips 3 über Verbindungsleitungen 8 in Form von Bond-Drähten kontaktiert. Bei der Ausführungsform gemäß Figur 11 sind die LED-Chips 3 untereinander in Reihe verschaltet, wobei ein erstes Ende der Reihenschaltung mit dem Bereich 25, der einteilig mit dem ersten Kontakt 2 ausgebildet ist, kontaktiert ist und das andere Ende mit dem anderen Bereich 25, der einteilig mit dem zweiten Kontakt 2' ausgebildet ist, kontaktiert ist.

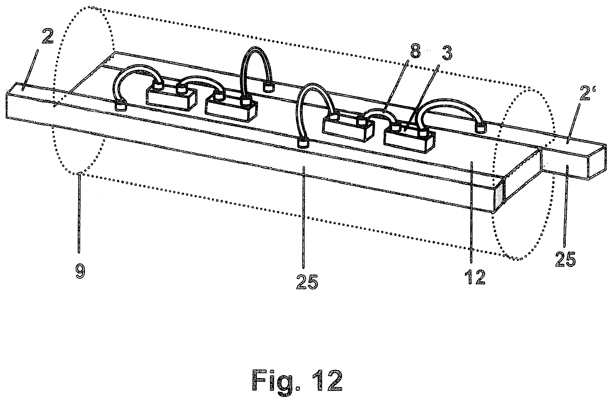

Fig. 12 zeigt eine perspektivische Darstellung eines weiteren LED-Streifens. Dieser unterscheidet sich von dem LED-Streifen gemäß Figur 11 dadurch, dass lediglich je zwei LED-Chips 3 zwischen den voneinander elektrisch isolierten Bereichen 25 in Reihe geschaltet und mehrere solcher Reihenschaltungen zwischen den voneinander elektrisch isolierten Bereichen 25 parallel geschaltet sind.

Mit einer solchen Konfiguration kann die Gesamtspannung des LED-Streifens unabhängig von dessen Gesamtlänge angepasst werden, indem jeweils Gruppen von gleich vielen LED-Chips 3 parallel geschaltet werden. Durch die Parallelschaltung erhöht sich auch die Anzahl der im Substrat 6"' verbauten Bond Drähte, die mit den Bereichen 25 des Metalls direkt verbunden sind. Dies führt aufgrund der Wärmeleitungseigenschaften der Bond Drähte zu einer gleichmäßigeren Wärmeverteilung im Substrat 6"'. Ein weiterer Vorteil der Parallelschaltung von Gruppen von LED-Chips 3 ist, dass bei der Verarbeitung der LED-Streifen ein "Auf-Länge-Schneiden" der LED-Streifen, das heiß ein Abschneiden oder Kappen der LED-Streifen auf eine gewünschte Länge angepasst an die jeweilige Anwendung möglich ist.

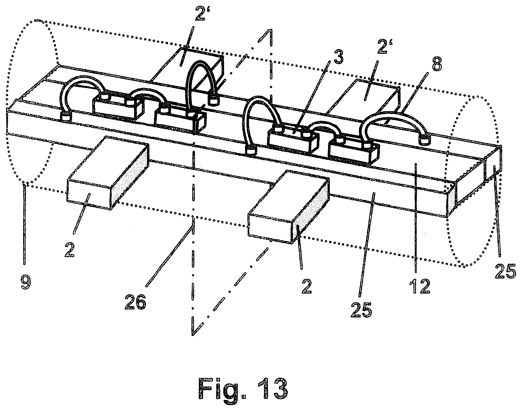

Fig. 13 zeigt eine perspektivische Darstellung eines weiteren LED-Streifens. Dieser unterscheidet sich von dem in Figur 12 gezeigten LED-Streifen dadurch, dass die zueinander parallel geschalteten Reihenschaltungen in Längsrichtung des Substrats voneinander beabstandet angeordnet sind. Des Weiteren sind mehrere Kontakte 2, 2' seitlich an den voneinander elektrisch isolierten Bereichen 25 angeordnet vorgesehen. Somit wird das "Auf-Länge-Schneiden" noch erleichtert, weil dieses dann in einem Zwischenraum zwischen voneinander beabstandet angeordneten Reihenschaltungen erleichtert vorgenommen werden kann, ohne diese zu beschädigen. Ferner ist dies auch unabhängig von der Kontaktierung möglich, da die seitlichen Kontakte 2, 2' beispielsweise seitlich vom Substrat weggeführt werden können.

Beispielsweise kann der LED-Streifen so in einer geeigneten eingezeichneten Schnittebene 26 zertrennt werden. Ein langer oder endlos-LED-Streifen kann so einfach auf die gewünschte Länge geschnitten und direkt kontaktiert werden.

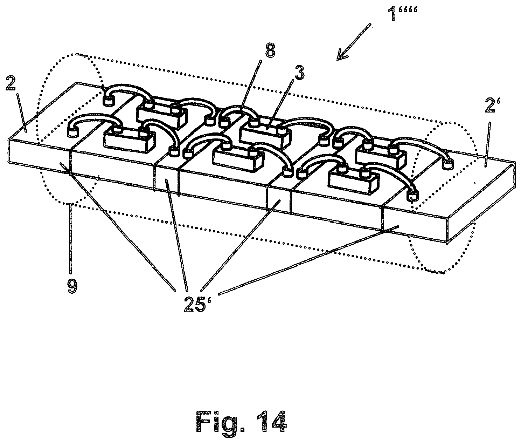

Fig. 14 zeigt eine perspektivische Darstellung eines weiteren LED-Streifens 1""'. Dieser weist ein Substrat 6""' auf, welches mehrere metallische, voneinander elektrisch isolierte Bereiche 25' und eine diese Bereiche 25' jeweils trennende transparente Matrix 12 aufweist. Die voneinander elektrisch isolierten Bereiche 25' sind dabei jeweils in Längsrichtung des Substrats 6"" voneinander beabstandet angeordnet.

Die an den längsseitigen Enden des Substrats 6"" angeordneten Bereiche 25' sind einteilig mit den Kontakten 2, 2' ausgebildet. Dazwischen sind mehrere weitere voneinander elektrisch isolierte Bereiche 25' angeordnet, wobei in Fig. 14 exemplarisch zwei dazwischen angeordnete Bereiche 25' abgebildet sind. Zwischen je zwei voneinander elektrisch isolierten Bereichen 25' sind jeweils mehrere zueinander parallel geschaltete LED-Chips angeordnet und kontaktiert, wobei in Fig. 14 exemplarisch jeweils zwei parallel geschaltete LED-Chips 3 abgebildet sind. Die an den längsseitigen Enden des Substrats 6"" angeordneten Bereiche 25' kontaktieren somit die randseitigen LED-Chips 3 des LED-Streifens 1""', während die zwischen den einzelnen LED-Chips 3 angeordneten voneinander elektrisch isolierte Bereiche 25' jeweils eine Zwischenkontaktierung bereitstellen, was die nachgelagerte Parallelschaltung weiterer LED-Chips zum jeweils nächsten elektrisch isolierten Bereich 25' ermöglicht.

Anstatt mehreren LED Chips können zwischen zwei voneinander elektrisch isolierten Bereichen 25' auch jeweils zumindest ein LED-Chip und ein anderes Halbleiterelement oder optoelektronisches Element parallel geschaltet angeordnet sein. Somit können andere Halbleiterelemente, z. B. TVS-Dioden, oder optoelektronische Elemente mit geringem Aufwand in den LED-Streifen eingefügt werden. Beide Varianten haben den Vorteil, dass durch die Parallelschaltung mehrerer Elemente die Länge des LED-Streifens auch verkürzt werden kann.

Bei den Ausführungsbeispielen gemäß Figur 11 bis 14 ist durch die voneinander elektrisch isolierten Bereiche des Metalls auch ein Besetzen einer Rückseite des LED-Streifens mit LED-Chips analog zur dargestellten Vorderseite möglich. Die voneinander elektrisch isolierten Bereiche 25, 25' des Metalls sind dazu auf beiden Seiten des LED-Streifens zur Kontaktierung vorgesehen. Ferner ist der gesamte LED-Streifen in eine schalenartige Umhüllung 9 eingelassen, welche eine Phosphor-Schicht enthält. Alternativ zu einer schalenartigen Umhüllung 9 könnte die Phosphor-Schicht auch auf die Flächen des LED-Streifens aufgebracht sein.

Unter voneinander elektrisch isolierten Bereichen 25, 25' sind solche Bereiche des Substrats 6"', 6"" zu verstehen, die metallische Leiter darstellen, aber aufgrund ihrer Anordnung nicht direkt miteinander in Kontakt stehen. Sie sind lediglich über die LED-Chips oder andere Halbleiterelemente oder optoelektronische Elemente indirekt elektrisch verbunden.

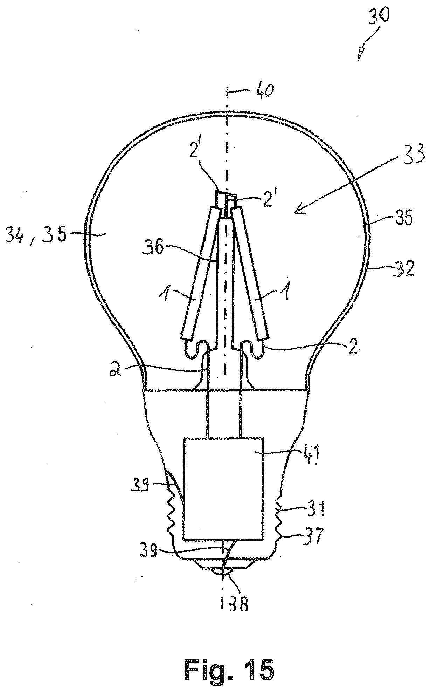

Figur 15 zeigt eine Retrofitlampe 30. Der prinzipielle Aufbau einer solchen Retrofitlampe wurde von der Anmelderin bereits in der DE 20 2013 009 434.6 U1 beschrieben, worauf Bezug genommen wird. Es wird im Folgenden daher nur kurz auf den grundsätzlichen Aufbau der Retrofitlampe eingegangen. Im Unterschied zu der Retrofitlampe der DE 20 2013 009 434.6 U1 werden hier LED-Streifen gemäß den vorstehenden Figuren 2, 3B, 4 bis 6 oder 9-14 eingesetzt.

Die Retrofitlampe 30 weist einen Lampensockel 31 und eine Hülle 32 auf. Die Hülle 32 ist mit dem Lampensockel 31 verbunden und zumindest teiltransparent ausgebildet. Ferner ist sie derart ausgebildet, als Kühlkörper für die Lampe 30 zu fungieren. Dazu ist eine wärmeleitende Beschichtung 35 an der Innenseite der Hülle 32 aufgebracht.

Im Inneren 35 der Hülle 32 ist eine Leuchtmittelanordnung 33 angeordnet, welche zwei LED-Streifen 1 gemäß einem der vorstehend beschriebenen Ausführungsbeispiele der Figuren 2 bis 6 enthält. Das Substrat der LED-Streifen ist vorzugsweise transparent und erlaubt so eine sogenannte 4n- Anordnung der LEDs, d.h. eine Lichtabstrahlung in alle Raumrichtungen.

Des Weiteren ist im Inneren 35 der Hülle 32 ein Wärmeübertragungsmedium 34 eingebracht. Das Wärmeübertragungsmedium ist dazu ausgebildet, von der Leuchtmittelanordnung erzeugte thermische Energie zu der als Kühlkörper fungierenden Hülle 32 zu transportieren.

Die LED-Streifen 1 sind mit Kontakten 2, 2' kontaktiert. Der obere, dem Lampensockel 31 abgewandte Kontakt 2' ist mittels einer Stützvorrichtung 36 am oberen Ende der LED-Strings 1 angeordnet. Im Bereich des Lampensockels 34 ist eine Ansteuerschaltung 41 vorgesehen, welche die Kontakte 2, 2' im Betrieb mit einer geeigneten Spannung und einem geeigneten Strom versorgt.

Der Lampensockel 31 weist äußerlich die Ausbildung eines Edison-Lampensockels mit einem Außenkontakt 37 und einem Fußkontakt 38 auf. Der Außen- und der Fußkontakt 37, 38 sind jeweils über eine elektrische Verbindungsleitung 39 mit der Ansteuerschaltung 41 verbunden.

Die Anordnung der LED-Strings 1 am Inneren 35 der Hülle 32 ist in Bezug auf die Lampenachse 40 leicht schräg. Dies dient der geringeren Verschattung durch interne Elemente der Lampe 30, wie die Stützvorrichtung 36 und/oder die Kontakte 2, 2'.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

Vorstehend wurde die Erfindung für einen LED-Streifen beschrieben. Sie ist jedoch nicht darauf beschränkt, sondern könnte auch vorteilhaft auf eine LED-Matrixanordnung übertragen werden, welche mehrere Reihen von LED-Chips auf einer Seite des Substrats aufweist. Unter dem Begriff eines LED-Streifens ist somit auch eine LED-Matrix zu verstehen.

### AUSFÜHRUNGSFORMEN

1. LED-Streifen (1; 1'; 1"), insbesondere für eine oder in einer Retrofit-Lampe (30),
   mit zumindest zwei Kontakten (2, 2') zum leitenden Kontaktieren des LED-Streifens (1; 1'),
   mit einer Vielzahl von entlang dem LED-Streifen (1; 1'; 1") angeordneten LED-Chips (3; 3', 3"), wobei die Kontakte (2, 2') und/oder die LED-Chips (3; 3', 3") derart an dem LED Streifen (1; 1'; 1") angeordnet sind, dass ihre Verteilung an das Temperaturprofil (T) im Betrieb des LED-Streifens (1; 1'; 1") angepasst ist und/oder dass das Temperaturprofil (T) im Betrieb des LED-Streifens (1; 1'; 1") geglättet ist.
2. LED-Streifen nach Ausführungsform 1,
   **dadurch gekennzeichnet,**
   dass die entlang dem LED-Streifen (1; 1'; 1") angeordneten LED-Chips (3; 3', 3") unterschiedlich weit voneinander beabstandet sind.
3. LED-Streifen nach Ausführungsform 1 oder 2,
   **dadurch gekennzeichnet,**
   dass die LED-Chips (3; 3', 3") in einem Nahbereich (4) der Kontakte (2, 2') geringer voneinander beabstandet sind als in einem Fernbereich (5) der Kontakte (2, 2').
4. LED-Streifen nach einer der vorstehenden Ausführungsformen,
   **dadurch gekennzeichnet,**
   dass der LED-Streifen (1') mit unterschiedliche Typen von LED-Chips (3', 3") besetzt ist, welche unterschiedliche
   Wärmeempfindlichkeiten aufweisen, wobei die wärmeempfindlicheren Typen von LED-Chips (3'), zumindest vorwiegend, im Nahbereich (4) der Kontakte (2, 2') angeordnet sind.
5. LED-Streifen nach einer der vorstehenden Ausführungsformen,
   **dadurch gekennzeichnet,**
   dass der LED-Streifen (1; 1'; 1") ein zumindest teiltransparentes Substrat (6; 6'; 6") enthält, welches eine im Vergleich zu Glas hohe, insbesondere zumindest zehnfach höhere, Wärmeleitfähigkeit aufweist.
6. LED-Streifen nach Ausführungsform 5,
   **dadurch gekennzeichnet,**
   dass das Substrat (6) ein Material enthält, welches elektrisch nicht leitend ist und/oder eine Kristallstruktur aufweist, insbesondere Saphir.
7. LED-Streifen nach Ausführungsform 5,
   **dadurch gekennzeichnet,**
   dass das Substrat (6', 6") ein Metall enthält.
8. LED-Streifen nach Ausführungsform 7,
   **dadurch gekennzeichnet,**
   dass das Metall eine gitterartige Ausbildung (11; 23) mit durchgehenden Ausnehmungen (13; 24) aufweist.
9. LED-Streifen nach Ausführungsform 8,
   **dadurch gekennzeichnet,**
   dass die gitterartige Ausbildung (11; 23) als Blech (23) mit Ausnehmungen (24), als Drahtgewebe (11) oder als Metallschwamm realisiert ist.
10. LED-Streifen nach Ausführungsform 7,
   **dadurch gekennzeichnet,**
   dass das Metall zwei voneinander elektrisch isolierte Bereiche ausbildet, welche sich zumindest abschnittsweise, insbesondere kontinuierlich, entlang der Längsausbildung des Substrats erstrecken.
11. LED-Streifen nach Ausführungsform 10,
   **dadurch gekennzeichnet,**
   dass die voneinander elektrisch isolierten Bereiche mit je einem der Kontakte (2, 2') kontaktiert sind und/oder zur elektrischen Kontaktierung der LED-Chips ausgebildet und angeordnet sind.
12. LED-Streifen nach Ausführungsform 11,
   **dadurch gekennzeichnet,**
   dass zumindest zwei LED-Chips zwischen den voneinander elektrisch isolierten Bereichen in Reihe geschaltet sind.
13. LED-Streifen nach Ausführungsform 12,
   **dadurch gekennzeichnet,**
   dass mehrere Reihenschaltungen von zumindest zwei LED-Chips zwischen den voneinander elektrisch isolierten Bereichen parallel geschaltet sind.
14. LED-Streifen nach Ausführungsform 13,
   **dadurch gekennzeichnet,**
   dass die zueinander parallel geschalteten Reihenschaltungen in Längsrichtung des Substrats voneinander beabstandet angeordnet sind.
15. LED-Streifen nach Ausführungsform 7,
   **dadurch gekennzeichnet,**
   dass das Metall zumindest zwei elektrisch isolierte Bereiche ausbildet, welche jeweils in Längsrichtung des Substrats voneinander beabstandet angeordnet sind.
16. LED-Streifen nach Ausführungsform 15,
   **dadurch gekennzeichnet,**
   dass die jeweils an einem längsseitigen Ende des Substrats angeordneten voneinander elektrisch isolierten Bereiche mit je einem der Kontakte (2, 2') kontaktiert sind und/oder zur elektrischen Kontaktierung der LED-Chips ausgebildet und angeordnet sind.
17. LED-Streifen nach Ausführungsform 16,
   **dadurch gekennzeichnet,**
   dass zwischen zwei voneinander elektrisch isolierten Bereichen je zumindest ein LED-Chip und ein anderes Halbleiterelement oder optoelektronisches Element parallel geschaltet sind.
18. LED-Streifen nach Ausführungsform 16,
   **dadurch gekennzeichnet,**
   dass zwischen zwei voneinander elektrisch isolierten Bereichen je zumindest zwei LED-Chips parallel geschaltet sind.
19. LED-Streifen nach einer der Ausführungsformen 8 bis 18,
   **dadurch gekennzeichnet,**
   dass das Substrat (6'; 6") eine transparente Matrix (12), insbesondere eine transparente Kunststoffmatrix, aufweist, welche zumindest im Bereich der Ausnehmungen (13) der gitterartigen Ausbildung (11) oder zumindest im Bereich zwischen zwei voneinander elektrisch isolierten Bereichen vorgesehen ist.
20. LED-Streifen nach einer der vorstehenden Ausführungsformen,
   **dadurch gekennzeichnet,**
   dass das Substrat (6; 6'; 6") an mehreren Seiten (7, 7') mit LED-Chips (3) besetzt ist.
21. LED-Streifen nach Ausführungsform 20,
   **dadurch gekennzeichnet,**
   dass an zumindest einem Endbereich (20) des LED-Streifens (1") eine Durchkontaktierung (21) von einer ersten zu einer zweiten mit LED-Chips (3) besetzten Seite (7, 7') des Substrats (6; 6') vorgesehen ist.
22. LED-Streifen nach einer der vorstehenden Ausführungsformen 2 bis 21,
   **dadurch gekennzeichnet,**
   dass die Kontakte (2, 2') längs des LED-Streifens (1; 1'; 1") voneinander beabstandet angeordnet sind und benachbarte LED-Chips (3; 3', 3") im Bereich der Mitte zwischen den zwei Kontakten (2, 2') im Vergleich zu anderen benachbarten LED-Chips (3; 3', 3") auf dem LED-Streifen (1) am weitesten voneinander beabstandet angeordnet sind.
23. LED-Streifen nach Ausführungsform 20,
   **dadurch gekennzeichnet,**
   dass die Kontakte (2, 2') im Bereich der Mitte des LED-Streifens (1") angeordnet sind.
24. LED-Streifen nach Ausführungsform 23,
   **dadurch gekennzeichnet,**
   dass benachbarte LED-Chips (3) in zumindest einem Endbereich (20) des LED-Streifens (1) im Vergleich zu anderen benachbarten LED-Chips (3) auf dem LED-Streifen (1) am weitesten voneinander beabstandet angeordnet sind.
25. LED-Streifen nach einer der vorstehenden Ausführungsformen,
   **dadurch gekennzeichnet,**
   dass die LED-Chips (3; 3', 3") in einer 4n-Anordnung derart angeordnet sind, dass sie in alle Raumrichtungen wirken.
26. Lampe (30), insbesondere Retrofit-Lampe,
   mit einem Lampensockel(31),
   mit einer mit dem Lampensockel (31) verbundenen, zumindest teiltransparenten geschlossenen Hülle (32), welche derart ausgebildet ist, als Kühlkörper für die Lampe (30) zu fungieren,
   mit einer Leuchtmittelanordnung (33), welche innerhalb der Hülle (32) angeordnet ist und zumindest einen LED-Streifen (1; 1'; 1") gemäß einer der vorstehenden Ausführungsformen aufweist,
   mit einem gasförmigen Wärmeübertragungsmedium (34), welches im Inneren (35) der Hülle (12) eingebracht ist und welches dazu ausgebildet ist, von der Leuchtmittelanordnung (33) erzeugte thermische Energie zu der als Kühlkörper fungierenden Hülle (32) zu transportieren.

### Bezugszeichenliste

- 1, 1', 1", 1"', 1"", 1""': LED-Streifen
- 2, 2': Kontakte
- 3, 3', 3'': LED-Chips
- 4: Nahbereich
- 5: Fernbereich
- 6, 6', 6", 6"', 6"": Substrat
- 7, 7': Seiten
- 8: Verbindungsleitungen
- 9: Umhüllung
- 10, 10', 10": Abstände

- 11: gitterartige Ausbildung bzw. Drahtgewebe
- 12: transparente Matrix 13 Ausnehmungen

- 20: Endbereiche
- 21: Durchkontaktierung
- 23: gitterartige Ausbildung bzw. Blech
- 24: Ausnehmungen
- 25: voneinander elektrisch isolierte Bereiche
- 26: Schnittebene

- 30: Lampe bzw. Retrofitlampe
- 31: Lampensockel
- 32: Hülle
- 33: Leuchtmittelanordnung
- 34: Wärmeübertragungsmedium
- 35: Inneres der Hülle
- 36: Stützvorrichtung
- 37: Außenkontakt
- 38: Fußkontakt
- 39: elektrische Verbindungsleitung
- 40: Lampenachse
- 41: Ansteuerschaltung

- 50: LED-Streifen
- 52, 52': Kontakte
- 53: LED-Chips
- 54: Substrat
- 55: Verbindungsleitungen

- T, A, B: Temperaturverlauf
- T1, T2: Temperatur

## Patentansprüche

1. LED-Streifen (1; 1'; 1") für eine oder in einer Retrofit-Lampe (30),
mit zumindest zwei Kontakten (2, 2') zum leitenden Kontaktieren des LED-Streifens (1; 1'),
mit einer Vielzahl von entlang dem LED-Streifen (1; 1'; 1") angeordneten LED-Chips (3; 3', 3"), wobei die Kontakte (2, 2') und/oder die LED-Chips (3; 3', 3'') derart an dem LED Streifen (1; 1'; 1") angeordnet sind, dass ihre Verteilung an das Temperaturprofil (T) im Betrieb des LED-Streifens (1; 1'; 1") angepasst ist und/oder dass das Temperaturprofil (T) im Betrieb des LED-Streifens (1; 1'; 1") geglättet ist,
wobei der LED-Streifen (1; 1'; 1") ein Substrat (6'; 6") enthält, welches ein Metall enthält, wobei das Metall zwei voneinander elektrisch isolierte Bereiche ausbildet, welche sich zumindest abschnittsweise, insbesondere kontinuierlich, entlang der Längsausbildung des Substrats erstrecken.

2. LED-Streifen nach Anspruch 1,
**dadurch gekennzeichnet,**
**dass** die voneinander elektrisch isolierten Bereiche mit je einem der Kontakte (2, 2') kontaktiert sind und/oder zur elektrischen Kontaktierung der LED-Chips ausgebildet und angeordnet sind.

3. LED-Streifen nach Anspruch 2,
**dadurch gekennzeichnet,**
**dass** zumindest zwei LED-Chips zwischen den voneinander elektrisch isolierten Bereichen in Reihe geschaltet sind, insbesondere mehrere Reihenschaltungen von zumindest zwei LED-Chips zwischen den voneinander elektrisch isolierten Bereichen parallel geschaltet und vorzugsweise in Längsrichtung des Substrats voneinander beabstandet angeordnet sind.

4. LED-Streifen (1; 1'; 1") für eine oder in einer Retrofit-Lampe (30),
mit zumindest zwei Kontakten (2, 2') zum leitenden Kontaktieren des LED-Streifens (1; 1'),
mit einer Vielzahl von entlang dem LED-Streifen (1; 1'; 1") angeordneten LED-Chips (3; 3', 3"), wobei die Kontakte (2, 2') und/oder die LED-Chips (3; 3', 3'') derart an dem LED Streifen (1; 1'; 1") angeordnet sind, dass ihre Verteilung an das Temperaturprofil (T) im Betrieb des LED-Streifens (1; 1'; 1") angepasst ist und/oder dass das Temperaturprofil (T) im Betrieb des LED-Streifens (1; 1'; 1") geglättet ist,
wobei der LED-Streifen (1; 1'; 1") ein Substrat (6'; 6") enthält, welches ein Metall enthält, wobei das Metall zwei voneinander elektrisch isolierte Bereiche ausbildet, welche jeweils in Längsrichtung des Substrats voneinander beabstandet angeordnet sind.

5. LED-Streifen nach Anspruch 4,
**dadurch gekennzeichnet,**
**dass** das Metall zumindest zwei jeweils an einem längsseitigen Ende des Substrats angeordnete voneinander elektrisch isolierte Bereiche ausbildet, die mit je einem der Kontakte (2, 2') kontaktiert sind und/oder zur elektrischen Kontaktierung der LED-Chips ausgebildet und angeordnet sind.

6. LED-Streifen nach Anspruch 5,
**dadurch gekennzeichnet,**
**dass** zwischen zwei voneinander elektrisch isolierten Bereichen je zumindest zwei LED-Chips parallel geschaltet sind oder zumindest ein LED-Chip und ein anderes Halbleiterelement oder optoelektronisches Element parallel geschaltet sind.

7. LED-Streifen nach einem der vorstehenden Ansprüche,
**dadurch gekennzeichnet,**
**dass** die entlang dem LED-Streifen (1; 1'; 1") angeordneten LED-Chips (3; 3', 3") unterschiedlich weit voneinander beabstandet sind, wobei die LED-Chips (3; 3', 3") in einem Nahbereich (4) der Kontakte (2, 2') bevorzugt geringer voneinander beabstandet sind als in einem Fernbereich (5) der Kontakte (2, 2').

8. LED-Streifen nach einem der vorstehenden Ansprüche,
**dadurch gekennzeichnet,**
**dass** der LED-Streifen (1') mit unterschiedliche Typen von LED-Chips (3', 3") besetzt ist, welche unterschiedliche Wärmeempfindlichkeiten aufweisen, wobei die wärmeempfindlicheren Typen von LED-Chips (3'), zumindest vorwiegend, im Nahbereich (4) der Kontakte (2, 2') angeordnet sind.

9. LED-Streifen nach einem der vorstehenden Ansprüche,
**dadurch gekennzeichnet,**
**dass** der LED-Streifen (1; 1'; 1") ein zumindest teiltransparentes Substrat (6; 6'; 6") enthält, welches eine im Vergleich zu Glas hohe, insbesondere zumindest zehnfach höhere, Wärmeleitfähigkeit aufweist und/oder dass das Substrat (6) ein Material enthält, welches elektrisch nicht leitend ist und/oder eine Kristallstruktur aufweist, insbesondere Saphir.

10. LED-Streifen nach einem der vorangehenden Ansprüche,
**dadurch gekennzeichnet,**
**dass** das Substrat (6'; 6") eine transparente Matrix (12), insbesondere eine transparente Kunststoffmatrix, aufweist, welche zumindest im Bereich zwischen zwei voneinander elektrisch isolierten Bereichen vorgesehen ist.

11. LED-Streifen nach einem der vorstehenden Ansprüche,
**dadurch gekennzeichnet,**
**dass** das Substrat (6; 6'; 6") an mehreren Seiten (7, 7') mit LED-Chips (3) besetzt ist.

12. LED-Streifen nach Anspruch 11,
**dadurch gekennzeichnet,**
**dass** an zumindest einem Endbereich (20) des LED-Streifens (1") eine Durchkontaktierung (21) von einer ersten zu einer zweiten mit LED-Chips (3) besetzten Seite (7, 7') des Substrats (6; 6') vorgesehen ist.

13. LED-Streifen nach einem der vorstehenden Ansprüche 7 bis 11,
**dadurch gekennzeichnet,**
**dass** die Kontakte (2, 2') längs des LED-Streifens (1; 1'; 1") voneinander beabstandet angeordnet sind und benachbarte LED-Chips (3; 3', 3") im Bereich der Mitte zwischen den zwei Kontakten (2, 2') im Vergleich zu anderen benachbarten LED-Chips (3; 3', 3'') auf dem LED-Streifen (1) am weitesten voneinander beabstandet angeordnet sind.

14. LED-Streifen nach Anspruch 11,
**dadurch gekennzeichnet,**
**dass** die Kontakte (2, 2') im Bereich der Mitte des LED-Streifens (1") angeordnet sind, wobei benachbarte LED-Chips (3) in zumindest einem Endbereich (20) des LED-Streifens (1) im Vergleich zu anderen benachbarten LED-Chips (3) auf dem LED-Streifen (1) bevorzugt am weitesten voneinander beabstandet angeordnet sind.

15. Lampe (30), insbesondere Retrofit-Lampe,
mit einem Lampensockel(31),
mit einer mit dem Lampensockel (31) verbundenen, zumindest teiltransparenten geschlossenen Hülle (32), welche derart ausgebildet ist, als Kühlkörper für die Lampe (30) zu fungieren,
mit einer Leuchtmittelanordnung (33), welche innerhalb der Hülle (32) angeordnet ist und zumindest einen LED-Streifen (1; 1'; 1") gemäß einem der vorstehenden Ansprüche aufweist,
mit einem gasförmigen Wärmeübertragungsmedium (34), welches im Inneren (35) der Hülle (12) eingebracht ist und welches dazu ausgebildet ist, von der Leuchtmittelanordnung (33) erzeugte thermische Energie zu der als Kühlkörper fungierenden Hülle (32) zu transportieren.
